# EUROPEAN PATENT SPECIFICATION

(11) **EP 0 305 168 B1**
(45) Date of publication and mention of the grant of the patent: **23.10.1996**
(21) Application number: 88307846.1
(22) Date of filing: 24.08.1988
(51) Int. Cl.: C04B 41/83, C04B 35/00, C04B 35/64, H01L 39/24

(54) **Superconducting ceramics and methods of manufacturing the same**
Supraleitende keramische Materialien und Verfahren zu ihrer Herstellung
Céramiques supraconductrices et leurs procédés de fabrication

(30) Priority: 27.08.1987 JP 214743/87
(43) Date of publication of application: 01.03.1989
(73) Proprietor: SEMICONDUCTOR ENERGY LABORATORY CO., LTD., Atsugi-shi Kanagawa-ken, 243 (JP)
(72) Inventor: Yamazaki, Shunpei, Tokyo (JP)
(74) Representative: Milhench, Howard Leslie

(56) References cited:
- APPLIED PHYSICS LETTERS, vol. 51, no. 7, 17 August 1987, American Institute of Physics, New York, NY (US); M.F. YAN et al., pp. 532, 534

## Description

### BACKGROUND OF THE INVENTION

This invention generally relates to the field of superconducting ceramics.

It has long been known that metals such as mercury and lead, intermetallics such as NbNd, Nb₃Ge and NbGa and ternary materials such as Nb₃(Al_{0.8}Ge_{0.2}) demonstrate superconductivity. However, the transition temperature of such long known conventional superconducting materials cannot exceed 25°K.

In more recent years, superconducting ceramics have attracted widespread interest. A new material was first reported by researchers at the Zurich laboratory of IBM Corp. as Ba-La-Cu-O-type high temperature superconducting oxides. Subsequently, La-Sr-Cu(II)-O-type superconducting oxides were also proposed. Another type of superconducting material that has been found is (YBa₂)Cu₃0₆₋₈. By virtue of the fact that these superconducting ceramics form a quasi-molecular atomic unit in a crystalline structure whose unit cell is constructed with one layer in which electrons have essentially one-dimensional motion, whereas three dimensional electron motion conditions occurs in the long known materials mentioned above, higher transition temperatures were achieved.

Much work has been undertaken by researchers in the field who have endeavoured to elevate Tco, the temperature at which resistance vanishes, above the levels previously obtained and preferably above the boiling point of liquid nitrogen (77°K) or even higher. As described in our European Patent Application No. 87309081.5 (EP-A-0283620), we have investigated superconducting ceramic materials having the stoichiometric formulae (A₁₋ₓBₓ)_{y}Cu_{z}O_{w}, where A represents one or more elements of Group IIIa of the Japanese Periodic Table, e.g. the rare earth elements, and B represents one or more elements of Group IIa of the Japanese Periodic Table, e.g. the alkaline earth elements including beryllium and magnesium, and in the continuation of these investigations we have discovered that contact of the external surfaces of superconductors with air makes it difficult to obtain a stabilized high Tco.

### SUMMARY OF THE INVENTION

According to the present invention there is provided a method of manufacturing a superconductive ceramics material comprising: mixing chemical constituents of the superconductive ceramics material; firing the mixture in order to produce the superconductive material; and coating the fired superconductive material on its external surface with a protective layer such that the superconductive material does not collect water from the atmosphere; the method being characterised in that prior to firing the mixture, said chemical constituents of the superconductive material are compacted with a reducing, water-free liquid in order to substantially reduce excess oxygen in said superconductive material.

Whereas in previous attempts to find commercially attractive superconducting materials, attention has been focused upon the elevation of Tc by modifying the composition of molar ratios of the constituent elements of the materials, in accordance with the present invention there is provided an improved process for the manufacture of superconductive ceramics in accordance with which, immediately after the formation of the superconducting structure, the superconducting body is coated with a protecting film such as an organic resin film for example in order that the superconducting body does not collect water from the surrounding atmosphere and particularly from the air, during cooling of the superconducting body to liquid nitrogen temperatures for initiating the transition to the superconducting phase. If water is absorbed into the superconducting material, the superconducting properties of the superconducting ceramics can be degraded.

The article "Water interaction with the superconducting YBa₂Cu₃O₇ phase" by M.F. Yan et al published in Applied Physics Letters, Vol.51, No. 7, 17 August 1987 on pages 532-534 discusses the sensitivity to water and water vapour of the superconducting ceramic material YBa₂Cu₃O₇ and concludes that this material is subject to decomposition in water and exhibits degraded superconductivity by the interaction of the material with water and humid air. There is a suggestion in the article that this effect need not preclude practical application of the material since it should be possible to protect it with coatings of metal, glass or plastic. There is however no suggestion in the article of compacting the constituents of the superconductive material with a reducing, water-free liquid in order to substantially reduce excess oxygen in the superconductive material.

In accordance with a preferred embodiment of the invention, the starting chemicals required for constituting a superconducting ceramics material are ground, compressed and fired. After repeating this procedure one or more times in order to obtain a uniform composition, the fine powder that results is mixed with a reducing, water-free liquid and compressed into a compact containing the liquid therein. The compact is gradually heated so as not to cause flash reduction, and is fired at 500-1400°C. The fired compact is then coated with an organic resin film immediately after its removal from the oven. Examples of such organic resins are epoxy resins, fluorine resins, silicone resins and polyimide resins. In accordance with experimental results that have been obtained, the critical temperature of the resulting superconductor was elevated to 150-400K.

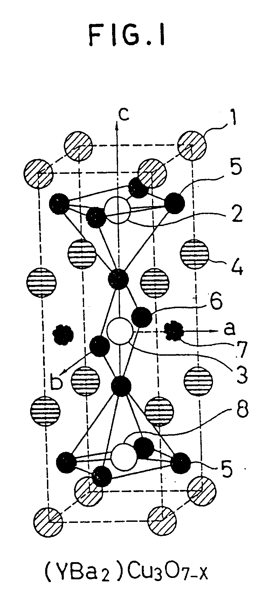

Superconducting materials in accordance with the present invention have a modified perovskite-like triple-layered structure as shown in Fig. 1 of the accompanying drawing. Each layer of the structure predominately comprises copper atoms 2 and oxygen atoms 5 located around the copper atoms 2. Oxygen vacancies 7 are considered to play an important role in superconduction. In order to eliminate excess oxygen from superconducting ceramics, a reducing water-free liquid is introduced into the ceramics material before firing. Examples of such reducing liquids are methyl alcohol, ethyl alcohol and fluorinated hydrocarbons such as Freon 113™. The reducing liquids react with oxygen contained in the ceramics material so as to produce water vapour and carbon dioxide which is eliminated during the firing of the ceramics. Because of the elimination of oxygen by this technique, the atomic distance along the C axis can be reduced and therefore very high critical temperatures can be obtained.

Other features of the invention are set forth with particularity in the appended claims and will become clear to those possessed of the relevant skills from consideration of the following description of the exemplary embodiments.

### BRIEF DESCRIPTION OF THE DRAWING

Fig. 1 is a diagram showing the modified perovskite-like structure of superconducting ceramics in accordance with the present invention.

### DETAILED DESCRIPTION OF THE EMBODIMENTS

Described hereinafter are a couple of examples illustrating the manufacture of superconducting ceramics conforming to the stoichiometric formulae (A₁₋ₓBₓ)_{y}Cu_{z}O_{w},where A is one or more elements of Group IIIa of the Japanese Periodic Table, e.g. the rare earth element, B is one or more elements of Group IIa of the Japanese Periodic Table, e.g. the alkaline earth metals including beryllium and magnesium, and 0 < x < 1; y = 2.0 - 4.0, preferably 2.5 - 3.5; z = 1.0 - 4.0, preferably 1.5 - 3.5; and w = 4.0 - 10.0, preferably 6.0 - 8.0. Examples of such materials are YBa₂Cu₃0₇₋ₓ and YCa₂Cu₃O₇₋ₓ.

For the avoidance of doubt it is to be noted that all references herein and in the appended claims to the Periodic Table and to specific Groups of the Periodic Table are to be understood to refer to the Japanese Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups Ia, IIa, VIII, Ib, IIb and 0 are the same in the Japanese and European Periodic Tables, Groups IIIa, IVa, Va, VIA and VIIa of the Japanese Periodic Table correspond respectively to Groups IIIb, IVb, Vb, VIb and VIIb of the European Periodic Table, and Groups IIIb, IVb, Vb, VIb and VIIb of the Japanese Periodic Table correspond respectively to Groups IIIa, IVa, Va, VIa and VIIa of the European Periodic Table.

### Example 1:

Prescribed amounts of BaCO₃, CaCO₃, CuO and Y₂O₃ (High Purity Chemical Industries Co. Ltd. 99.95% or higher) were used for preparing a superconducting ceramic material of the above formula where x=0.67, y=3, z=3 and w=6-8. i.e. in consistence with (YBa₂)-Cu₃O₆₋₈ or (YBaCa)Cu₃O₆₋₈. The factor "W" was controlled by adjusting the sintering conditions.

After being mixed in a ball mill, the high purity chemicals were pressed in a capsule at 500KN/m²(500Kg/cm²) and formed into a cylindrical tablet of 10mm diameter and 3mm height. The tablet was heated (fired) and oxidized at 500-1100°C, e.g. 950°C, for 8 hours in an oxidizing atmosphere such as in air, this step being called pre-firing hereinafter. Next, the tablet was finely ground in a ball mill so that the average grain diameter was 20-0.003 µm, e.g. 0.5 µm or smaller. This step is repeated 3-5 times. In this step, it is desired to take care to avoid the occurrence of Y₂BaCuO₅ or a copper oxide phase in the product.

Then, the powder of 20-0.003 µm average diameter was sufficiently mixed with methyl alcohol in a ball mill, and was pressed in a capsule at a pressure of 1000KN/m²(1 t/cm²) so as to be formed into tablets.

The tablets were then fired, hereinafter called main firing, for 10 - 50 hours at 500-1400°C, for example 15 hours at 930°C, in an oxidizing atmosphere such as in air. This firing was carried out by elevating the temperature from room temperature to the prescribed temperature at 10 - 1000°C per hour, e.g. at 100°C per hour. While the temperature was being elevated, the ceramic material was partially reduced by virtue of the alcohol. Thereafter, the temperature was reduced to 400°C at 100°C per minute.

By virtue of this procedure, a dense perovskite-like structure was obtained. Next, the tablet was covered with a resin coating by immersion in a silicone resin solution followed by thermal setting at 150°C for two hours or 30 minutes in dehumidified air. Alternatively the tablets could be coated with an epoxy resin, in which case thermal setting is carried out at 150°C for 30 minutes or 240°C for 5 minutes in air.

The relationship between temperature and the resistivity of the resultant material was investigated. When the temperature was lowered from 250K, the resistivity started to drop at around 250K and disappeared at 248K. This critical temperature of 248K was repeatedly observed when the temperature was repeatedly raised and lowered between room temperature and the critical temperature. For comparison, the same superconducting ceramic material was fabricated without provision of the resin coating and upon examination was found to have a critical temperature which dropped to 93K when the temperature was repeatedly raised and lowered.

The organic resin used for covering the superconducting materials of the invention is preferably selected from soft resins, because local stress in superconducting materials caused by contraction or expansion of the resin during curing is undesirable.

### Example 2.

The procedure of Example 1 was repeated but with 50% of Y substituted by Yb and Ca substituted by Sr, and with a fluorinated hydrocarbon in place of methyl alcohol. The Y and Yb were introduced as oxides or fluorides. As a result, Tc onset was measured to be 300°K and Tco was 297°K, which were maintained for a week or long term.

The foregoing Examples are merely illustrative of the invention, and do not include all of the combinations of elements and process variations which may be used to produce superconducting ceramics materials in accordance with the invention, other combinations also being effective to provide improved superconducting materials.

Superconducting ceramics for use in accordance with the present invention also may be prepared so as to be consistent with the stoichiometric formulae (A₁₋ₓbₓ)_{y}Cu_{z}O_{w}Xᵥ, where A is one or more elements of Group IIIa of the Japanese Periodic Table, e.g. the rare earth elements, B is one or more elements of Group IIA of the Japanese Periodic Table e.g. the alkaline earth metals including beryllium and magnesium, X is one or more elements of the group consisting of Ge, Sn, Pb, F or Cl, and 0 < x <1; y = 2.0 - 4.0, preferably 2.5 - 3.5; z = 1.0 - 4.0, preferably 1.5 - 3.5; w = 4.0 - 10.0, preferably 6.0 - 8.0; and v = 0 - 3. An example of such a material is YBa₂Cu₃O₆₋₈. Also, superconducting ceramics for use in accordance with the present invention may be prepared so as to be consistent with the stoichiometric formulae (A₁₋ₓBₓ)_{y}Cu_{z}O_{w}, where A is one or more elements of Group Vb of the Japanese Periodic Table such as Bi, Sb and As, B is one or more elements of Group IIa of the Japanese Periodic Table, e.g. the alkaline earth metals, and x = 0.3 - 1; y = 2.0 - 4.0, preferably 2.5 - 3.5; z = 1.0 - 4.0, preferably 1.5 - 3.5; and w = 4.0 - 10.0, preferably 6.0 - 8.0. An example of such a material is BiCaSrCu₃O₆₋₈.

While several embodiments have been specifically described, it is to be appreciated that the present invention is not limited to the particular examples described. For example, diamond-like carbon can be used for protecting the surface of superconducting ceramic films. A suitable process for the formation of carbon materials can be seen in our European Patent Application No. 88301364.1(EP-A-0284190). Also, the application of a magnetic field during main-firing is effective for aligning the crystalline axis of the resultant material.

## Claims

1. A method of manufacturing a superconductive ceramics material comprising:
mixing chemical constituents of the superconductive ceramics material;
firing the mixture in order to produce the superconductive material; and
coating the fired superconductive material on its external surface with a protective layer such that the superconductive material does not collect water from the atmosphere;
the method being characterised in that prior to firing the mixture, said chemical constituents of the superconductive material are compacted with a reducing, water-free liquid in order to substantially reduce excess oxygen from said superconductive material.

2. A method as claimed in claim 1 wherein the reducing liquid is an alcohol, such as methyl alcohol or ethyl alcohol, or a fluorinated hydrocarbon.

3. A method as claimed in claim 1 or 2 wherein the protective layer comprises an organic resin or a diamond-like carbon film.

4. A method as claimed in claim 3 wherein said organic resin comprises an epoxy resin, a fluorine resin, a polyimide resin or a silicone resin.

5. A method as claimed in any of the preceding claims wherein said chemical constituents are mixed in accordance with the stoichiometric formula (A₁₋ₓBₓ)_{y}Cu_{z}O_{w}, where A is one or more elements from Group IIIa of the Japanese Periodic Table or Group Vb of the Japanese Periodic Table such as Bi, Sb and As, B is one or more elements of Group IIa of the Japanese Periodic Table, and x = 0.3 - 1; y = 2.0 - 4.0, z = 1.0 - 4.0 and w = 4.0 - 10.0.

6. A method as claimed in any of claims 1 to 4 wherein the chemical constituents are mixed in accordance with the stoichiometric formula (A₁₋ₓBₓ)_{y}Cu_{z}O_{w}Xᵥ, where A is one or more elements of IIIa of the Japanese Periodic Table, B is one or more elements of Group IIa of the Japanese Periodic Table, X is one or more elements of the group consisting of Ge, Sn, Pb, F or Cl, and O<x<1, y = 2.0 - 4.0, z = 1.0 - 4.0, w = 4.0 - 10.0, and v = 0-3.

7. A method as claimed in any of the preceding claims wherein said chemical constituents are subjected to prefiring after a first mixing step, and then are finely ground prior to said compacting step.

8. A method as claimed in any of the preceding claims and including a thermal setting step following the coating of the superconductive material with the protective layer.

9. A method as claimed in any of the preceding claims wherein a magnetic field is applied to the material during its firing for aligning the crystalline axis of the resultant material.

## Patentansprüche

1. Verfahren zur Herstellung eines supraleitenden Keramikwerkstoffs, wobei
chemische Bestandteile des supraleitenden Keramikwerkstoffs gemischt werden,
das Gemisch zur Erzeugung des supraleitenden Werkstoffs gebrannt wird und
der gebrannte supraleitende Werkstoff an seiner Außenfläche mit einer Schutzschicht überzogen wird, so daß er kein Wasser aus der Atmosphäre aufnimmt,
dadurch **gekennzeichnet**, daß die chemischen Bestandteile des supraleitenden Werkstoffs vor dem Brennen des Gemisches mit einer reduzierenden, wasserfreien Flüssigkeit verdichtet werden, um überschüssigen Sauerstoff aus dem supraleitenden Werkstoff im wesentlichen zu reduzieren.

2. Verfahren nach Anspruch 1, wobei die reduzierende Flüssigkeit ein Alkohol, etwa Methyl- oder Ethylalkohol, oder ein Fluorkohlenwasserstoff ist.

3. Verfahren nach Anspruch 1 oder 2, wobei die Schutzschicht einen Film aus organischem Harz oder diamantartigem Kohlenstoff umfaßt.

4. Verfahren nach Anspruch 3, wobei das organische Harz ein Epoxy-, Fluor-, Polyimid- oder Siliconharz enthält.

5. Verfahren nach einem der vorhergehenden Ansprüche, wobei die chemischen Bestandteile entsprechend der stöchiometrischen Formel (A₁₋ₓBₓ)_{y}Cu_{z}O_{w} gemischt werden, wobei A ein oder mehrere Elemente der Gruppe IIIa des japanischen Periodensystems oder der Gruppe Vb des japanischen Periodensystems, wie etwa Bi, Sb und As; und B ein oder mehrere Elemente der Gruppe IIa des japanischen Periodensystems bedeutet; x = 0,3 bis 1; y = 2,0 bis 4,0; z = 1,0 bis 4,0; und w = 4,0 bis 10,0 ist.

6. Verfahren nach einem der Ansprüche 1 bis 4, wobei die chemischen Bestandteile entsprechend der stöchiometrischen Formel (A₁₋ₓBₓ)_{y}Cu₂O_{w}Xᵥ gemischt werden, wobei A ein oder mehrere Elemente der Gruppe IIIa des japanischen Periodensystems; B ein oder mehrere Elemente der Gruppe IIa des japanischen Periodensystems; und X ein oder mehrere der Elemente Ge, Sn, Pb, F oder Cℓ bedeutet; 0 < x < 1; y = 2,0 bis 4,0; z = 1,0 bis 4,0; w = 4,0 bis 10,0; und v = 0-3 ist.

7. Verfahren nach einem der vorhergehenden Ansprüche, wobei die chemischen Bestandteile nach einem ersten Mischvorgang vorgebrannt und danach vor dem Verdichtungsvorgang feingemahlen werden.

8. Verfahren nach einem der vorhergehenden Ansprüche, wobei dem Überziehen des supraleitenden Werkstoffs mit der Schutzschicht eine Wärmeaushärtung folgt.

9. Verfahren nach einem der vorhergehenden Ansprüche, wobei der Werkstoff während des Brennens einem Magnetfeld ausgesetzt wird, um die Kristallachse des sich ergebenden Werkstoffs auszurichten.

## Revendications

1. Procédé de fabrication d'une matière céramique supraconductrice qui comprend :
le mélange des constituants chimiques de la matière céramique supraconductrice ;
la cuisson du mélange afin de produire la matière supraconductrice ; et
le revêtement de la matière supraconductrice cuite sur sa surface externe par une couche protectrice de telle sorte que la matière supraconductrice ne recueille pas d'eau de l'atmosphère ;
le procédé étant caractérisé en ce qu'avant la cuisson du mélange, on comprime lesdits constituants chimiques de la matière supraconductrice avec un liquide réducteur, exempt d'eau, afin de réduire de manière importante l'oxygène en excès de ladite matière supraconductrice.

2. Procédé selon la revendication 1, dans lequel le liquide réducteur est un alcool tel que l'alcool méthylique ou l'alcool éthylique ou un hydrocarbure fluoré.

3. Procédé selon la revendication 1 ou 2, dans lequel la couche protectrice comprend une résine organique ou un film de carbone de type diamant.

4. Procédé selon la revendication 3, dans lequel ladite résine organique comprend une résine époxy, une résine fluorée, une résine de polyimide ou une résine de silicone.

5. Procédé selon l'une quelconque des revendications précédentes, dans lequel on mélange lesdits constituants chimiques conformément à la formule stoechiométrique (A₁₋ₓBₓ)_{y}Cu_{z}O_{w}, dans laquelle A représente un ou plusieurs éléments du groupe IIIa du Tableau Périodique Japonais ou du groupe Vb du Tableau Périodique Japonais tel que Bi, Sb et As, B représente un ou plusieurs éléments du groupe IIa du Tableau Périodique Japonais et x = 0,3-1 ; y = 2,0-4,0 ; z = 1,0-4,0 et w = 4,0-10,0.

6. Procédé selon l'une quelconque des revendications 1 à 4, dans lequel on mélange les constituants chimiques conformément à la formule stoechiométrique (A₁₋ₓBₓ)_{y}Cu_{z}O_{w}Xᵥ, dans laquelle A représente un ou plusieurs éléments du groupe IIIa du Tableau Périodique Japonais, B représente un ou plusieurs éléments du groupe IIa du Tableau Périodique Japonais, X représente un ou plusieurs éléments du groupe constitue par Ge, Sn, Pb, F ou Cl et 0 < x < 1, y = 2,0-4,0, z = 1,0-4,0,
w = 4,0-10,0 et v = 0-3.

7. Procédé selon l'une quelconque des revendications précédentes, dans lequel on soumet lesdits constituants chimiques à une précuisson après une première étape de mélange et ensuite on les broie finement avant ladite étape de compression.

8. Procédé selon l'une quelconque des revendications précédentes et comprenant une étape de prise thermique après le revêtement de la matière supraconductrice avec la couche protectrice.

9. Procédé selon l'une quelconque des revendications précédentes, dans lequel on applique un champ magnétique à la matière au cours de sa cuisson afin d'aligner les axes cristallins de la matière résultante.
